# EUROPÄISCHE PATENTANMELDUNG

(11) **EP 1 560 338 A1**
(43) Veröffentlichungstag der Anmeldung: **03.08.2005**
(21) Anmeldenummer: 04001690.9
(22) Anmeldetag: 27.01.2004
(51) Int. Cl.: H03M 7/30, G05B 23/02, H03M 1/12

(54) **Verfahren zur Speicherung von Prozesssignalen einer technischen Anlage**

(71) Anmelder: SIEMENS AKTIENGESELLSCHAFT, 80333 München (DE)
(72) Erfinder: Bode, Andreas, 91315 Höchstadt (DE); Hempl, Martin, 90610 Winkelhaid (DE)

(57) **Zusammenfassung**

Bei einem erfindungsgemäßen Verfahren zur Speicherung von Prozesssignalen (5) einer technischen Anlage wird abhängig von einem aktuellen Betriebszustand (I,II) der technischen Anlage ein dem aktuellen Betriebszustand (I,II) angepasstes Komprimierungsverfahren auf die Menge der Prozesssignale (5) angewendet und eine dabei ermittelte komprimierte Prozesssignalmenge (25) gespeichert.

## Beschreibung

Die Erfindung betrifft ein Verfahren zur Speicherung von Prozesssignalen einer technischen Anlage, wobei während des Betriebs der technischen Anlage eine Anzahl an, den verschiedenen Prozessen zugeordneten, Prozesssignalen anfallen, die einer Speicherung zugeführt werden sollen.

Um das Verhalten einer technischen Anlage während des Betriebs oder im Nachhinein beurteilen zu können, ist es erforderlich, eine meist große Anzahl an Prozesssignalen, die während des Betriebs anfallen, abzuspeichern und deren zeitlichen Verlauf zu analysieren.

Üblicherweise stammen diese Prozesssignale aus unterschiedlichen Komponenten der technischen Anlage und müssen zu einem Datenbestand zusammengeführt und entsprechend festgelegter Auswertekriterien beurteilt werden.

Selbst bei einer Anlage mittlerer Größe entsteht bereits nach kurzer Zeit eine große Fülle an Prozesssignalen, deren Speicherung und Weiterverarbeitung beispielsweise zu Diagnosezwecken schnell die zur Verfügung stehenden Ressourcen verbraucht oder überfordert.

Engpässe entstehen dabei üblicherweise direkt bei der Abspeicherung infolge des enormen Speicherplatzbedarfs, bei der Weiterverarbeitung beispielsweise mittels Analysealgorithmen, wobei diese Algorithmen einen sehr großen Datenbestand bearbeiten müssen, oder bei der Übertragung der abgespeicherten Prozesssignale an einen Auswerterechner, der die abgespeicherten Prozesssignale z.B. per Fernabfrage abruft, insbesondere über das Internet.

Besonders im letztgenannten Fall sind die Übertragungszeiten sehr lange, wenn der Bestand an gespeicherten Prozesssignalen sehr groß ist.

Um diese Probleme zu überwinden, ist es bekannt, die Prozesssignale vor ihrer Speicherung einer Komprimierung zu unterziehen, so dass der für die Speicherung benötigte Speicherplatz reduziert ist.

Nachteilig dabei ist, dass insbesondere bei Komprimierungsverfahren, welche eine hohe Komprimierungsrate aufweisen, Informationen über das zeitliche Verhalten der Prozesssignale verloren gehen, die dringend benötigt werden, um eine detaillierte Betrachtung eines Betriebszustands der Anlage durchführen zu können.

Der Erfindung liegt daher die Aufgabe zugrunde, ein verbessertes Verfahren zur Speicherung von Prozesssignalen einer technischen Anlage anzugeben, welches einen reduzierten Speicherplatzbedarf aufweist und bei welchem insbesondere ein Verlust an wichtigen in den Prozesssignalen enthaltenen Informationen vermieden ist.

Die Aufgabe wird erfindungsgemäß gelöst durch ein Verfahren zur Speicherung von Prozesssignalen einer technischen Anlage, bei welchem abhängig von einem aktuellen Betriebszustand der technischen Anlage ein dem aktuellen Betriebszustand angepasstes Komprimierungsverfahren auf die Menge der Prozesssignale angewendet und eine dabei ermittelte komprimierte Prozesssignalmenge gespeichert wird.

Die Erfindung geht dabei von der Überlegung aus, dass Verfahren zur Datenkomprimierung immer einen Kompromiss bilden zwischen reduziertem Speicherplatzbedarf und Informationsverlust.

Eine Schonung der Speicherplatzressourcen bedeutet somit zwangsläufig einen Verlust an Information. Umgekehrt bedeutet ein weitestgehendes Erhalten des Informationsgehalts eine reduzierte Komprimierungsrate.

Beim erfindungsgemäßen Verfahren ist daher vorgesehen, das verwendete Komprimierungsverfahren auf den jeweils aktuellen Betriebszustand anzupassen. Dies bedeutet, dass beispielsweise während einer Betriebsphase, während derer sich die zu speichernden Prozesssignale nur wenig ändern, ein Komprimierungsverfahren mit hoher Kompressionsrate verwendet wird, wohingegen in Betriebsphasen, während derer sich die Prozesssignale stark verändern, ein Komprimierungsverfahren mit niedriger Kompressionsrate verwendet wird.

Das verwendete Komprimierungsverfahren kann auch dahingehend ausgewählt werden, ob eine Kurzzeitanalyse oder eine Langzeitanalyse der zu speichernden Prozesssignale beabsichtigt ist. Bei einer Langzeitanalyse, bei welcher die während eines langen Zeitraums anfallenden Prozesssignale abgespeichert und danach analysiert werden sollen, bietet sich ein Komprimierungsverfahren mit hoher Komprimierungsrate an, da bei einer Langzeitanalyse vorwiegend signifikante Signaländerungen betrachtet werden sollen und nicht unbedingt jede kleine Signaländerung von Bedeutung ist.

Dahingegen interessieren bei einer Kurzzeitanalyse auch kleinere Signaländerungen, weshalb sich dabei ein Komprimierungsverfahren mit niedriger Komprimierungsrate anbietet.

Vorteilhaft werden die Prozesssignale gleichzeitig erfasst, so dass die Menge der Prozesssignale zu einem bestimmten Zeitpunkt korrespondiert.

Dadurch ist bei einem Vergleich zweiter Mengen an Prozesssignalen, die zu zwei verschiedenen Zeitpunkten erfasst wurden ("Finger prints"), eine hohe Genauigkeit des Vergleichs gegeben, da jeder Zeitpunkt zu einem momentanen Betriebszeitpunkt der Anlage korrespondiert und dadurch zwei Betriebspunkte genau miteinander verglichen werden können.

In einer vorteilhaften Ausgestaltung der Erfindung ändert sich der Betriebszustand der Anlage und es werden mindestens zwei unterschiedliche Komprimierungsverfahren angewendet.

Bei dieser Ausführungsform dienen die mindestens zwei unterschiedlichen Komprimierungsverfahren dazu, den speziellen Anforderungen eines sich ändernden Betriebszustands hinsichtlich einer Auswertung der dabei anfallenden Prozesssignale Rechnung zu tragen.

Beispielsweise weist eine Turbinenanlage mindestens zwei Betriebsphasen auf, nämlich eine Startphase mit sich üblicherweise stark verändernden Prozesssignalen und einen Normalbetrieb, welcher sich an die Startphase anschließt und während welchem die anfallenden Prozesssignale eher konstant oder zumindest sich weniger stark verändernd verlaufen.

Der Betriebszustand in der Startphase ist also insbesondere durch sich stark verändernde Prozesssignale gekennzeichnet, welche bevorzugt einem Komprimierungsverfahren mit niedriger Komprimierungsrate unterworfen werden, um den Verlust an Information weitestgehend zu verhindern.

Die Betriebsphase des Normalbetriebs hingegen zeichnet sich durch eher konstant verlaufende Prozesssignale aus, weshalb das während dieses Betriebszustands zur Verwendung vorgesehene Komprimierungsverfahren bevorzugt ein Komprimierungsverfahren mit großer Komprimierungsrate ist.

Die mindestens zwei unterschiedlichen Komprimierungsverfahren können sich neben einer unterschiedlichen Komprimierungsrate auch dadurch unterscheiden, dass ein technisch und/oder mathematisch jeweils andersartiges Komprimierungsverfahren zum Einsatz kommt, welches dem jeweils vorherrschenden Betriebszustand geeignet angepasst ist.

In einer weiteren bevorzugten Ausführungsform umfasst das Komprimierungsverfahren eine Erfassung der Prozesssignale in festlegbaren Zeitabständen.

Beim Betrieb der Anlage fallen die Prozesssignale üblicherweise kontinuierlich an und werden mittels Sensoren abgegriffen. Die Ausgangssignale der Sensoren können nun entweder kontinuierlich abgespeichert werden, beispielsweise mittels eines analogen Schreibers, oder sie werden nur in bestimmten Zeitabständen abgetastet und die zu den Abtastzeitpunkten vorliegenden Signalwerte abgespeichert, wobei die zwischen den Abtastzeitpunkten anfallenden Prozesssignalwerte verloren gehen.

Bei der vorliegenden Ausführungsform ist vorgesehen, dass die beim Komprimierungsverfahren verwendete Abtastfrequenz durch Einstellung des Zeitabstandes zwischen zwei Abtastungen veränderbar ist. Ein kurzer Zeitabstand zwischen zwei Abtastungen führ zu einer niedrigen Komprimierungsrate und eignet sich besonders zur Speicherung von Prozesssignalen während eines Betriebszustands, während welchem die Prozesssignale noch nicht eingeschwungen sind und daher eine stärkere zeitliche Veränderung aufweisen.

Ein größerer zeitlicher Abstand zwischen zwei Abtastungen führt zu einer hohen Komprimierungsrate und ist besonders geeignet für Betriebszustände, während welcher die Prozesssignale bereits eingeschwungen sind und daher in der Regel keinen starken Veränderungen unterworfen sind.

Falls während des Betriebszustands, in welchem die Prozesssignale eingeschwungen sind, eine Störung auftritt, so kann dies sofort als neuer Betriebszustand erkannt und ein anderes Komprimierungsverfahren verwendet werden, beispielsweise ein Komprimierungsverfahren mit kürzeren Zeitabständen zwischen zwei Abtastungen der Prozesssignale.

Folglich wird die Größe der Zeitabstände vorteilhaft abhängig vom aktuellen Betriebszustand der Anlage gewählt.

In einer weiteren Ausführungsform der Erfindung umfasst das Komprimierungsverfahren eine Untersuchung mindestens eines der Prozesssignale daraufhin, ob das Prozesssignal seit seiner letzten Speicherung innerhalb eines Amplitudenbandes verblieben ist und wie lange der Zeitpunkt seiner letzten Speicherung zurückliegt, wobei eine Speicherung des Prozesssignals nur dann vorgenommen wird, wenn der Zeitpunkt seiner letzten Speicherung länger als ein vorgegebenes Zeitintervall zurückliegt.

Bei dieser Ausführungsform findet eine Verdichtung (Komprimierung) der anfallenden Prozesssignale zur Speicherung vorrangig dadurch statt, dass das oder die betreffenden Prozesssignale nur dann erneut gespeichert werden, wenn sich deren aktuelle Werte seit ihrer letzten Speicherung stärker verändert haben als eine vorgegebene Änderung (Amplitudenband). Dadurch wird verhindert, dass der aktuelle Wert des oder der Prozesssignale laufend abgespeichert wird, obwohl sich deren Wert nur leicht verändert hat. Eine leichte Veränderung bedeutet in diesem Zusammenhang, dass sich der aktuelle Wert des Prozesssignals im Vergleich zum zuvor gespeicherten Wert des selben Prozesssignals immer noch im Amplitudenband befindet.

Bei der vorliegenden Ausführungsform ist weiterhin vorgesehen, dass das Prozesssignal trotz seines Verbleibs im Amplitudenband erneut abgespeichert wird, wenn der Zeitpunkt seiner letzten Speicherung lange genug zurückliegt. Folglich wird bei dieser Ausführungsform der Wert des Prozesssignals nicht zu jedem Abtastzeitpunkt gespeichert, sondern erst nach Ablauf des vorgegebenen Zeitintervalls, dessen Größe vorab festgelegt oder auch abhängig vom aktuellen Betriebszustand ermittelt werden kann.

So werden auch kleinere Änderungen des Prozesssignals gespeichert, aber nicht zu jedem Abtastzeitpunkt, sondern nur nach Ablauf des vorgegebenen Zeitintervalls, welches bevorzugt größer ist als der Zeitabstand zwischen zwei Abtastzeitpunkten. Dies spart Speicherplatz und erlaubt gleichzeitig das Erkennen auch kleinerer Signaländerungen, auch wenn der zeitliche Verlauf des Prozesssignals innerhalb des Amplitudenbandes liegt.

Im Unterschied dazu werden bei herkömmlichen Komprimierungsverfahren derartige, langsam driftende Prozesssignale nicht unterschiedliche behandelt, sondern diese werden als vermeintlich konstant betrachtet. Bei herkömmlichen Verfahren tritt daher ein Informationsverlust ein.

Bevorzugt umfasst das Komprimierungsverfahren eine Untersuchung mindestens eines der Prozesssignale daraufhin, ob das Prozesssignal seit seiner letzten Speicherung ein weiteres Amplitudenband verlassen hat, wobei eine Speicherung des Prozesssignals erst nach dem Verlassen des weiteren Amplitudenbands vorgenommen wird.

Die Komprimierung der zu speichernden Prozesssignale findet bei dieser Ausführungsform dadurch statt, dass nicht jede Signaländerung des Signals speichermäßig erfasst wird, sondern dass eine Speicherung nur dann stattfindet, wenn das Prozesssignal sich "stark genug" geändert hat, dass also sein Wert das vorgegebene weitere Amplitudenband verlassen hat.

Alle Werte des Prozesssignals, die vom weiteren Amplitudenband umfasst sind, werden nicht erneut abgespeichert, sondern der vorangehende Wert des Prozesssignals wird solange als konstanter Prozesssignalwert angenommen, bis der aktuelle Wert des Prozesssignals das weitere Amplitudenband verlässt. Dadurch ist der Speicherplatzbedarf stark reduziert.

Besonders bevorzugt wird die Größe des Amplitudenbandes und/oder des weiteren Amplitudenbandes abhängig vom aktuellen Betriebszustand der Anlage gewählt.

Die Größe des Amplitudenbandes bestimmt im Wesentlichen die Komprimierungsrate des Komprimierungsverfahrens. Während eines Betriebszustands, der einem gewünschten Normalbetrieb entspricht, kann beispielsweise die Größe des Amplitudenbandes und/oder des weiteren Amplitudenbandes groß gewählt werden, da sich bei einem derartigen Betriebszustand die zu speichernden Prozesssignale meist wenig verändern.

Sobald die Anlage diesen Betriebszustand verlässt und beispielsweise in einen Übergangsbetriebszustand oder einen gestörten Betriebszustand übergeht, wird die Größe des Amplitudenbandes bevorzugt kleiner gewählt im Vergleich zum Normalbetrieb. Betriebszustände außerhalb des Normalbetriebs erfordern meist eine rückschauende Analyse der gespeicherten Prozesssignale, bei der es auch auf kleinere Signaländerungen ankommt, um beispielsweise die Ursachen einer Störung oder ein gewünschtes Übergangsverhalten der Prozesssignale zu verifizieren.

Zur weiteren Einsparung von Speicherplatz können Prozesssignale, deren aktuelle Werte in einer Umgebung eines Nullpunkts liegen, mit dem Wert Null gespeichert werden.

Oftmals weisen Prozesssignale infolge von Ungenauigkeiten bei der Erfassung oder bei deren Weiterverarbeitung Werte auf, die praktisch Null sind, aber formell z.B. infolge von Messwertrauschen einen Wert ungleich Null aufweisen. Werden die verrauschten Prozesssignalwerte weiterverarbeitet, bedeutet dies einen erhöhten Rechenaufwand und eventuell Folgefehler bei der Weiterverarbeitung.

Bei der vorliegenden Ausführungsform wird dies verhindert, indem eine Umgebung um den Nullpunkt festgelegt wird, innerhalb welcher der Wert Null für die betreffenden Prozesssignale postuliert und gespeichert wird. Im Vergleich zur Abspeicherung verrauschter Prozesssignalwerte benötigt die Speicherung des Werts Null erheblich weniger Speicherplatz und verhindert darüber hinaus Folgefehler bei der Weiterverarbeitung der Prozesssignalwerte.

In einer besonders bevorzugten Ausführungsform werden die Prozesssignale zunächst in einem Vorlaufpuffer gespeichert und erst danach mittels des dem aktuellen Betriebszustand angepassten Komprimierungsverfahrens bearbeitet und als komprimierte Prozesssignalmenge gespeichert, wobei der aktuelle Betriebszustand zu einem anderen Zeitpunkt korrespondiert als der Zeitpunkt der Speicherung der Prozesssignale im Vorlaufpuffer.

Im Vorlaufpuffer befinden sich die Prozesssignale in zunächst unkomprimierter Form. Die Komprimierung der Prozesssignale findet erst danach statt, wenn ausgehend von einem (zeitlich später liegenden) aktuellen Betriebszustand quasi rückwirkend das Komprimierungsverfahren dem aktuellen Betriebszustand angepasst wird. Auf diese Weise ist erreicht, dass Prozesssignale, welche z.B. im Vorfeld einer Betriebszustandänderung angefallen sind, mit einem Komprimierungsverfahren bearbeitet werden, welches bereits dem neuen, geänderten Betriebszustand angepasst ist. Bei einer Störung kann so z.B. ein Komprimierungsverfahren mit niedriger Komprimierungsrate auch auf solche Prozesssignale angewendet werden, die bereits vor dem Eintritt der Störung angefallen sind. Wie weit diese rückwirkende Anpassung des Komprimierungsverfahrens zurück in die Vergangenheit stattfinden kann, hängt u.a.von der Größe des Vorlaufpuffers.

Mit anderen Worten werden bei dieser Ausführungsform die Prozesssignale zunächst in den Vorlaufpuffer geschrieben - beispielsweise für einen Zeitraum von 30 Sek. - und erst danach wird abhängig von dem dann vorliegenden aktuellen Betriebszustand entschieden, welches Komprimierungsverfahren für die eigentliche Speicherung der Prozesssignale zur Anwendung kommen soll. Insofern korrespondiert der Zeitpunkt oder Zeitraum des aktuellen Betriebszustands nicht mit dem Zeitpunkt der Speicherung der Prozesssignale im Vorlaufpuffer; vielmehr liegt der Zeitpunkt der Speicherung der Prozesssignale im Vorlaufpuffer vor dem Zeitpunkt oder Zeitraum des aktuellen Betriebszustands.

Es ist weiterhin vorteilhaft, wenn die Prozesssignale bezüglich einer Verletzung eines Grenzwerts überwacht werden.

Der Grenzwert kann dabei beispielsweise einen Maximalwert repräsentieren, den das Prozesssignal gerade noch annehmen darf, ohne den Betrieb der Anlage zu gefährden. Eine Verletzung dieses Grenzwerts kann dann beispielsweise mit einer Warnmeldung verknüpft und ausgegeben und/oder gespeichert werden.

Besonders vorteilhaft wird der Grenzwert dabei abhängig vom aktuellen Betriebszustand der Anlage festgelegt.

Im Folgenden wird ein Ausführungsbeispiel der Erfindung näher dargestellt.

Es zeigt:
- FIG: das zeitliche Verhalten eines Prozesssignals zur Veranschaulichung des erfindungsgemäßen Verfahrens.

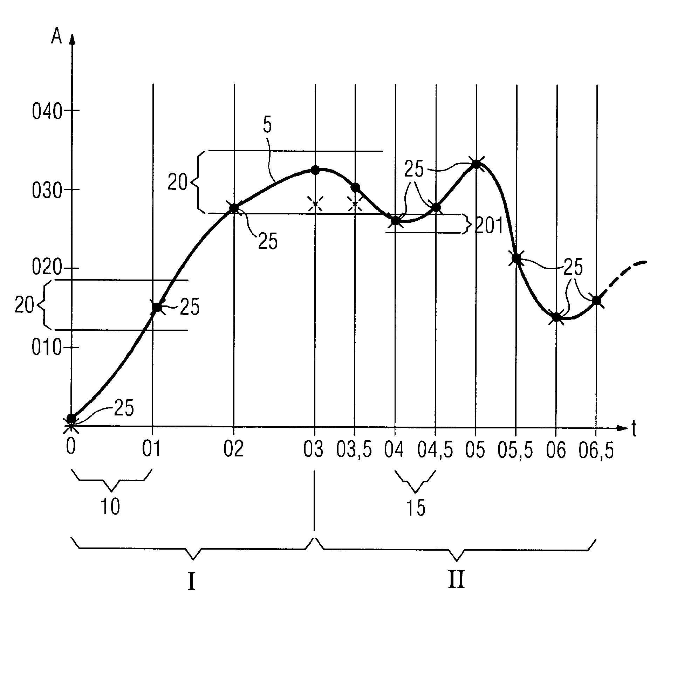

In der Figur ist ein Prozesssignal 5 dargestellt, welches sich während der Zeit t ändert.

Während der Zeitdauer t = 0 bis t = 03 steigt das Prozesssignal 5 von einem Wert nahe 0 auf einen Wert in der Gegend von 030 an. Der Anstieg des Prozesssignals 5 ist dabei kontinuierlich und es treten keine oder nur kleine Schwingungen oder Steigungsänderungen ein.

Ab dem Zeitpunkt t = 03 neigt das Prozesssignal 5 zu Schwingungen und stärkeren Amplitudenänderungen. Dies könnte beispielsweise bei einer technischen Anlage verursacht sein durch einen Lastwechsel, der zum Zeitpunkt t = 03 eintritt.

Dieser Betriebszustand ist in der Figur mit dem Bezugszeichen II gekennzeichnet; der vorangehende Betriebszustand, während welchem der Wert des Prozesssignals 5 weniger stark schwankt und beispielsweise ein normales Anfahren der Anlage repräsentiert, ist mit dem Bezugszeichen I gekennzeichnet.

Der zeitliche Verlauf des Werts des Prozesssignals 5 wird als Signalamplitude A bezeichnet.

Während der Zeitdauer des Betriebszustands I wird die Signalamplitude A des Prozesssignals 5 in Zeitabständen 10 abgetastet und der dabei ermittelte Amplitudenwert gespeichert, falls der zum jeweiligen Abtastzeitpunkt vorliegende Wert des Prozesssignals 5 ein Amplitudenband 20 verlassen hat. Im vorliegenden Ausführungsbeispiel ist dies im Zeitraum t = 02 bis t = 03,5 nicht der Fall; abgespeichert wird während des Zeitraums t = 0 bis t = 03,5 eine komprimierte Prozesssignalmenge 25, die lediglich drei Werte umfasst, wobei der Wert des Prozesssignals 5 zum Zeitpunkt t = 0 als Wert 0 abgespeichert wird, da vernünftigerweise zu diesem Zeitpunkt ein Signalrauschen angenommen wird und als richtiger Wert für das Prozesssignal 5 zum Zeitpunkt t = 0 der Wert 0 angenommen wird.

Eine Komprimierung der zu speichernden Prozesssignale findet dabei dahingehend statt, dass bis zum Zeitpunkt t = 03,5 zwar fünf Signalabtastungen stattfinden, aber nur drei Werte als komprimierte Prozesssignalmenge 25 gespeichert werden.

Das Amplitudenband 20 ist dabei ein Kriterium dafür, ob der aktuelle Wert des Prozesssignals 5 beim nächsten Abtastzeitpunkt erneut abgespeichert wird oder nicht. Beim vorliegenden Ausführungsbeispiel führt das dazu, dass der Wert des Prozesssignals 5 zum Zeitpunkt t = 02 bis zum Zeitpunkt t = 04 abgespeichert bleibt und eine erneute Speicherung des aktuellen Prozesssignalwerts erst zum Zeitpunkt t = 04 stattfindet.

Während des Betriebszustands I findet eine Abtastung des Prozesssignals 5 im Zeitabstand 10 statt, welcher eine Größe von einer Zeiteinheit aufweist. Die Größe dieser Zeiteinheit ist dem Betriebszustand I angepasst, da dabei die Änderungen des Prozesssignals 5 nicht stark ausfallen und daher ein größeres Abtastzeitintervall und damit eine höhere Komprimierungsrate ausreichend sind.

Ab dem Zeitpunkt t = 03 wechselt der Betriebszustand I zum Betriebszustand II, während welchem stärkere Schwankungen und Steigungsänderungen des Prozesssignals 5 stattfinden. Deshalb wird ab dem Zeitpunkt t = 03 eine Abtastung in einem weiteren Zeitabstand 15 vorgenommen, welcher im Vergleich zum Zeitabstand 10 kleiner ist und zu einer häufigeren Abtastung des Prozesssignals 5 während des Betriebszustands II im Vergleich zum Betriebszustand I führt. Der zeitliche Abstand zwischen zwei Abtastungen ist im Betriebszustand II eine halbe Zeiteinheit und damit die dort verwendete Abtastfrequenz doppelt so hoch wie im Betriebszustand I.

Um auch kleinere Änderungen des Prozesssignals 5 zu speichern und rückwirkend erkennen zu können, wird ein weiteres Amplitudenband 201 vorgegeben, dessen Größe infolge des geänderten Betriebszustands II kleiner gewählt wird als das Amplitudenband 20, welches überwiegend dem Betriebszustand I zuzurechnen ist.

Da der Wert des Prozesssignals 5 zum Zeitpunkt t = 04,5 im Vergleich zum Wert des Prozesssignals 5 zum Zeitpunkt t = 04 das weitere Amplitudenband 201 verlassen hat, findet sowohl zum Zeitpunkt t = 04 als auch zum Zeitpunkt t = 04,5 eine Speicherung des Prozesssignals 5 statt.

Während des Betriebszustands II ist daher die Komprimierungsrate des Komprimierungsverfahrens niedriger.

Beim vorliegenden Ausführungsbeispiel kann weiterhin ein Vorlaufpuffer vorgesehen sein, in welchem die Werte des Prozesssignals 5 zunächst unkomprimiert geschrieben werden und erst danach mit einem Komprimierungsverfahren bearbeitet werden, welches dem aktuellen Betriebszustand angepasst ist.

Beispielsweise können die Prozesssignalwerte im Zeitraum t = 0 bis t = 03 zunächst in kurzen Zeitabständen abgetastet werden, beispielsweise in einem Zeitabstand einer viertel Zeiteinheit oder kleiner. Anhand des zum Zeitpunkt t = 03 vorliegenden aktuellen Betriebszustand wird dann z.B. rückwirkend entschieden, welchem Komprimierungsverfahren die im Vorlaufpuffer vorab bereits abgelegten Prozesssignale rückwirkend unterworfen werden.

Zum Zeitpunkt t = 03 liegt noch der Betriebszustand I vor, und aufgrund dessen wird quasi für die Vergangenheit rückwirkend festgelegt, dass das Prozesssignal 5 nur im Zeitabstand 10 abgetastet und dabei zur zusätzlichen Komprimierung das Amplitudenband 20 angewendet wird.

Der Vorlaufpuffer hat dabei z.B. eine Größe zur Aufnahme des zeitlichen Verlaufs des Prozesssignals 5 während des Zeitraums t = 0 bis t = 03. Der absolute Speicherbedarf des Vorlaufpuffers ist abhängig von der verwendeten Abtastrate beim Schreiben in den Vorlaufpuffer.

Der Vorlaufpuffer dient insbesondere dazu, Prozesssignale im Vorfeld einer Betriebszustandsänderung mit einer gewünschten Genauigkeit und Zeit-/Amplitudenauflösung speichern zu können.

Der aktuelle Betriebszustand ist dabei ausschlaggebend für die Auswahl des Komprimierungsverfahrens für historische, zurückliegende Prozesssignalwerte im Vorlaufpuffer.

## Patentansprüche

1. Verfahren zur Speicherung von Prozesssignalen (5) einer technischen Anlage,
**dadurch gekennzeichnet, dass**
abhängig von einem aktuellen Betriebszustand (I,II) der technischen Anlage ein dem aktuellen Betriebszustand (I,II) angepasstes Komprimierungsverfahren auf die Menge der Prozesssignale (5) angewendet und eine dabei ermittelte komprimierte Prozesssignalmenge (25) gespeichert wird.

2. Verfahren nach Anspruch 1,
**dadurch gekennzeichnet, dass** die Prozesssignale gleichzeitig erfasst werden, sodass die Menge der Prozesssignale zu einem bestimmten Zeitpunkt korrespondiert.

3. Verfahren nach Anspruch 1 oder 2,
**dadurch gekennzeichnet, dass**
sich der Betriebszustand (I,II) der Anlage während ihres Betriebs ändert und mindestens zwei unterschiedliche Komprimierungsverfahren angewendet werden.

4. Verfahren nach einem der Ansprüche 1 bis 3,
**dadurch gekennzeichnet, dass**
das Komprimierungsverfahren eine Erfassung der Prozesssignale in festlegbaren Zeitabständen (10,15) umfasst.

5. Verfahren nach Anspruch 4,
**dadurch gekennzeichnet, dass**
die Größe der Zeitabstände (10,15) abhängig vom aktuellen Betriebszustand (I,II) der Anlage gewählt wird.

6. Verfahren nach einem der Ansprüche 1 bis 5,
**dadurch gekennzeichnet, dass**
das Komprimierungsverfahren eine Untersuchung mindestens eines der Prozesssignale (5) daraufhin umfasst, ob das Prozesssignal (5) seit seiner letzten Speicherung innerhalb eines Amplitudenbandes (20) verblieben ist und wie lange der Zeitpunkt seiner letzten Speicherung zurück liegt, wobei eine Speicherung des Prozesssignals (5) nur dann vorgenommen wird, wenn der Zeitpunkt seiner letzten Speicherung länger als ein vorgegebenes Zeitintervall zurück liegt.

7. Verfahren nach einem der Ansprüche 1 bis 6,
**dadurch gekennzeichnet, dass**
das Komprimierungsverfahren eine Untersuchung mindestens eines der Prozesssignale (5) daraufhin umfasst, ob das Prozesssignal (5) seit seiner letzten Speicherung ein weiteres Amplitudenband (201) verlassen hat, wobei eine Speicherung des Prozesssignals (5) erst nach dem Verlassen des weiteren Amplitudenbands (201) vorgenommen wird.

8. Verfahren nach Anspruch 6 oder 7,
**dadurch gekennzeichnet, dass**
die Größe des Amplitudenbandes (20) und/oder des weiteren Amplitudenbandes (201) abhängig vom aktuellen Betriebszustand (I,II) der Anlage gewählt wird.

9. Verfahren nach einem der Ansprüche 1 bis 8,
**dadurch gekennzeichnet, dass**
Prozesssignale (5), deren aktuelle Werte in einer Umgebung eines Nullpunkts liegen, mit dem Wert Null gespeichert werden.

10. Verfahren nach einem der Ansprüche 1 bis 9,
**dadurch gekennzeichnet, dass**
die Prozesssignale (5) zunächst in einem Vorlaufpuffer gespeichert werden und erst danach mittels des dem aktuellen Betriebszustands (I,II) angepassten Komprimierungsverfahrens bearbeitet und als komprimierte Prozesssignalmenge (25) gespeichert werden, wobei der aktuelle Betriebszustand (I,II) zu einem anderen Zeitpunkt korrespondiert als der Zeitpunkt der Speicherung der Prozesssignale (5) im Vorlaufpuffer.

11. Verfahren nach einem der Ansprüche 1 bis 10,
**dadurch gekennzeichnet, dass**
die Prozesssignale (5) bezüglich einer Verletzung eines Grenzwerts überwacht werden.

12. Verfahren nach Anspruch 11,
**dadurch gekennzeichnet, dass** der Grenzwert abhängig vom jeweils aktuellen Betriebszustand (I,II) der Anlage festgelegt wird.
